# EUROPÄISCHE PATENTSCHRIFT

(11) **EP 1 424 641 B1**
(45) Veröffentlichungstag und Bekanntmachung des Hinweises auf die Patenterteilung: **20.05.2009**
(21) Anmeldenummer: 02026498.2
(22) Anmeldetag: 28.11.2002
(51) Int. Cl.: G06F 17/50

(54) **Verfahren und Einrichtung zum ermitteln der minimalen oder maximalen schaltaktivität einer digitalschaltung**
Method for determining the minimum or the maximum switching activity of a digital circuit
Méthode pour déterminer le minimum ou le maximum de l'activité de commutation d'un circuit digital

(43) Veröffentlichungstag der Anmeldung: 02.06.2004
(73) Patentinhaber: Onespin Solutions GmbH, 80339 München (DE)
(72) Erfinder: Höreth, Stefan, Dr., 85625 Glonn (DE)
(74) Vertreter: Hofmann, Harald

(56) Entgegenhaltungen:
- SATYANARAYANA J H ET AL: "Systematic analysis of bounds on power consumption in pipelined and non-pipelined multipliers" PROCEEDINGS OF THE INTERNATIONAL CONFERENCE ON COMPUTER DESIGN. ICCD. VLSI IN COMPUTERS AND PROCESSORS. AUSTIN, OCT. 7 - 9, 1996, LOS ALAMITOS, IEEE COMP. SOC. PRESS, US, 7. Oktober 1996 (1996-10-07), Seiten 492-499, XP010201842 ISBN: 0-8186-7554-3
- BOBBA S ET AL: "Estimation of Maximum Switching Activity in Digital VLSI Circuits" CIRCUITS AND SYSTEMS, 1997. PROCEEDINGS OF THE 40TH MIDWEST SYMPOSIUM ON SACRAMENTO, CA, USA 3-6 AUG. 1997, NEW YORK, NY, USA,IEEE, US, 3. August 1997 (1997-08-03), Seiten 1130-1133, XP010272271 ISBN: 0-7803-3694-1
- BHANJA S ET AL: "Switching activity estimation of large circuits using multiple Bayesian networks" PROCEEDINGS OF ASP-DAC/VLSI DESIGN 2002. 7TH ASIA AND SOUTH PACIFIC DESIGN AUTOMATION CONFERENCE AND 15H INTERNATIONAL CONFERENCE ON VLSI DESIGN, PROCEEDINGS 7TH ASIA AND SOUTH PACIFIC DESIGN AUTOMATION CONFERENCE. 15H INTERNATIONAL CONFERENCE ON VLS, 1. Juli 2002 (2002-07-01) - 1. November 2002 (2002-11-01), Seiten 187-192, XP002241228 2002, Los Alamitos, CA, USA, IEEE Comput. Soc, USA ISBN: 0-7695-1441-3

## Beschreibung

Die folgende Erfindung betrifft ein Verfahren bzw. eine Vorrichtung zum Ermitteln einer minimalen oder einer maximalen Schaltaktivität einer Digitalschaltung anhand eines funktionalen Modells der Digitalschaltung, sowie ein digitales Speichermedium mit Steuersignalen zur Durchführung des Verfahrens mittels einer Datenverarbeitungseinrichtung.

Dem Entwurf verlustleistungsarmer digitaler Signale kommt immer wachsende Bedeutung zu. Schon heute wäre beispielsweise der Betrieb von mobilen Endgeräten wie Mobiltelefonen oder tragbaren Computersystemen ohne den Einsatz von Maßnahmen zur Reduktion der Leistungsaufnahme nicht praktikabel. Die Leistungsaufnahme eines digitalen Systems bzw. einer Digitalschaltung wird in erheblichem Maß von der Schaltaktivität der Digitalschaltung bestimmt. Für den Entwurf von Digitalschaltungen mit geringem Leistungsverbrauch sind präzise Aussagen über die maximale bzw. minimale Leistungsaufnahme unabdingbar. Ein wesentliches Entwurfsziel solcher Schaltungen ist neben der funktionalen Korrektheit auch das Einhalten der Vorgaben für den Leistungsverbrauch.

Zur Abschätzung der Leistungsaufnahme bzw. der Schaltaktivität ist es bei herkömmlichen Verfahren bekannt, die Digitalschaltung mit vom Anwender vorgegebenen Testvektoren zu beaufschlagen, wobei die Aussagekraft der gewonnenen Abschätzung der Leistungsaufnahme bzw. Schaltaktivität maßgeblich von der Qualität der vorgegebenen Testvektoren abhängt. Diese Vorgehensweise ist damit fehleranfällig und kann zu unerlaubt optimistischen Leistungsabschätzungen führen, was in der Praxis nachteilige Folgen hat und sogar bis zum Systemausfall führen kann.

Ein entsprechendes Verfahren ist durch die EP 863 470 A1 bekannt, in der ein Verfahren zur Erzeugung der Funktion der Leistungsaufnahme eines funktionalen Modells eines digitalen Schaltkreises beschrieben ist, bei welchem Verfahren eine Schaltungsbeschreibung erzeugt wird, bei der die Leistungsaufnahme ermittelbar ist. Diese Schaltungsbeschreibung wird einer Simulation unterzogen, bei der Eingabemuster verwendet werden, um die Funktion der Leistungsaufnahme zu ermitteln. Nachteiligerweise hängen die ermittelten Werte für die Leistungsaufnahme maßgeblich von den verwendeten Testmustern bzw. Eingabemustern ab. Die Qualität der Abschätzung der Leistungsaufnahme wird somit maßgeblich vom Geschick bei der Auswahl der Testmuster bestimmt, so dass bei ungünstig gewählten Testmustern die Leistungsaufnahme falsch eingeschätzt wird.

Der vorliegenden Erfindung liegt daher die Aufgabe zu Grunde, ein Verfahren bzw. eine zur Durchführung des Verfahrens eingerichtete Vorrichtung sowie ein in Verbindung mit einer programmierbaren Datenverarbeitungseinrichtung zur Durchführung des Verfahrens eingerichtetes digitales Speichermedium mit Steueranweisungen zu schaffen, bei denen ausgehend von einer Beschreibung einer Digitalschaltung deren minimale oder maximale Schaltaktivität zuverlässig ermittelt werden kann.

Diese Aufgabe wird erfindungsgemäß durch ein Verfahren mit den Merkmalen des Anspruchs 1 oder des Anspruchs 4 bzw. eine Vorrichtung mit den Merkmalen des Anspruchs 10 oder des Anspruchs 12 bzw. ein Speichermedium mit den Merkmalen des Anspruchs 14 gelöst. Die Unteransprüche definieren jeweils bevorzugte und vorteilhafte Ausführungsformen der vorliegenden Erfindung.

Erfindungsgemäß wird die minimale oder maximale Schaltaktivität einer Digitalschaltung anhand dessen Modells iterativ in Schritten bestimmt, wobei in jedem Schritt zunächst ein Schätzwert für die minimale oder maximale Schaltaktivität festgelegt wird und anschließend verifiziert wird, ob der Schätzwert für die minimale oder maximale Schaltaktivität tatsächlich ein Extremwert sein kann. Diese Verifikation geschieht erfindungsgemäß durch den Versuch eines Gegenbeweises, bei dem nach einem Betriebsfall gesucht wird, in dem die Schaltaktivität der Digitalschaltung noch größer bzw. kleiner als der ursprünglich angenommene Schätzwert für die maximale bzw. minimale Schaltaktivität der Digitalschaltung ist. Das Führen dieses Gegenbeweises besteht in dem Versuch, einen Betriebsfall aufzufinden, der die ursprünglich getroffene Annahme widerlegt, der Schätzwert für die maximale bzw. minimale Schaltaktivität wäre tatsächlich ein Extremwert.

Wenn ein Nachweisbetriebsfall bzw. ein Widerlegungsbetriebsfall gefunden werden kann, der die ursprüngliche Annahme widerlegt, wird der ursprünglich angenommene Schätzwert im nächsten Schritt der Iteration erhöht bzw. erniedrigt, um dem tatsächlichen Wert für die maximale bzw. minimale Schaltaktivität der Digitalschaltung näher zu kommen. Wenn die maximale Schaltaktivität gesucht wird, wird bei der Verifizierung nach einem Widerlegungsbetriebsfall gesucht, bei dem die Schaltaktivität größer als der Schätzwert im jeweiligen Schritt ist, und wird der Schätzwert zum nächsten Schritt hin erhöht, wenn kein Widerlegungsbetriebsfall gefunden werden kann bzw. doch noch eine höhere Schaltaktivität der Digitalschaltung als der ursprünglich angenommene Schätzwert möglich sein muss, und wird der Schätzwert erniedrigt, wenn kein Widerlegungsbetriebsfall gefunden werden kann.

Wird dagegen die minimale Schaltaktivität der Digitalschaltung gesucht, so wird bei der Verifizierung nach einem Widerlegungsbetriebsfall gesucht, bei dem die Schaltaktivität der Digitalschaltung geringer als der Schätzwert im jeweiligen Schritt ist. Wird ein solcher Widerlegungsbetriebsfall gefunden, wird der Schätzwert zum nächsten Schritt der Iteration hin weiter verringert, und wird kein Widerlegungsbetriebsfall gefunden, so wird der Schätzwert zum nächsten Schritt hin erhöht.

Die Schaltaktivität der Digitalschaltung kann dabei vorteilhafterweise als die Anzahl der Elemente innerhalb der Digitalschaltung definiert sein, die einen logischen Zustand speichern können und innerhalb einer zu wählenden Zeitbasis ihren Zustand ändern. Derartige Schaltungselemente, die einen logischen Zustand speichern können, sind insbesondere Kippglieder wie beispielsweise Flipflops. Als Zeitbasis kann insbesondere ein Takt der Digitalschaltung verwendet werden, wobei vorzugsweise bei jedem Takt ein Wechsel des logischen Zustands jedes Kippglieds bzw. Speicherelements möglich sein soll. Die Schaltaktivität kann somit als ganze Zahl ausgedrückt werden, die auf eine Zeitbasis bezogen wird, wobei in der Regel die Zeitbasis ein Taktschritt ist, so dass die Schaltaktivität eine einfache ganze Zahl ist.

Vorteilhafterweise wird der Schätzwert von einem Iterationsschritt zum nächsten um eine Schrittweite erhöht oder erniedrigt, die sich von Iterationsschritt zu Iterationsschritt stetig verringert. Auf diese Weise nähert sich im Laufe der Iteration der Schätzwert für die maximale oder minimale Schaltaktivität immer mehr dem jeweiligen tatsächlichen Wert an. Dabei kann die Schrittweite von jedem Iterationsschritt zum nächsten auf verschiedene Weisen verringert werden. Eine Möglichkeit besteht darin, die Schrittweite zum nächsten Iterationsschritt hin jeweils zu halbieren oder durch einen bestimmten Faktor zu teilen. Weiterhin kann die Schrittweite im Fall einer Erhöhung auch anders bemessen sein als im Fall einer Erniedrigung. Weiterhin kann für den Schätzwert und insbesondere für die Schrittweite zum Erhöhen oder Erniedrigen des Schätzwerts nicht ein Absolutwert verwendet werden, sondern ein Teil einer Bezugsgröße, die vorteilhafterweise der theoretisch maximal möglichen Schaltaktivität der Digitalschaltung entspricht. Dieser theoretische Maximalwert, der als Bezugsgröße verwendet werden soll, ist insbesondere die Anzahl der Kippglieder innerhalb der Digitalschaltung. Zu den Kippgliedern sollen in diesem Fall alle Schaltungselemente gezählt werden, die einen logischen Zustand speichern können.

Wenn die Anzahl der Kippglieder als theoretischer Maximalwert für die Schaltaktivität verwendet wird, so gilt dies vorzugsweise nur, wenn als Zeitbasis ein Taktschritt der Digitalschaltung verwendet wird. Als theoretischer Maximalwert für die Schaltaktivität kann jedoch auch ein Vielfaches der Anzahl der Kippglieder der Digitalschaltung verwendet werden, wenn als Zeitbasis ebenso ein Vielfaches an Taktschritten der Digitalschaltung verwendet wird.

Die zur Durchführung der erfindungsgemäßen Lehre erforderliche Verifikation bzw. das Auffinden eines Widerlegungsbetriebsfalls kann auf verschiedene Weisen durchgeführt werden. Insbesondere wird die Verifikation durchgeführt, indem anhand des Modells der Digitalschaltung eine oder mehrere logische Funktionen erstellt werden, die den logischen Zustand an einigen oder allen innerhalb der Digitalschaltung vorkommenden Schaltelementen in Abhängigkeit von einem Betriebsfall beschreiben. Als Betriebsfall wird allgemein die Summe der Umstände verstanden, die reproduzierbar zu einem bestimmten Zustand der Digitalschaltung führen. Ein Betriebsfall umfasst insbesondere ein bestimmtes Muster von Eingangsgrößen und den zeitlichen Ausgangszustand der Digitalschaltung, sofern dieser das Verhalten der Digitalschaltung bestimmt. Ein Ziel bei der Verifikation ist es, den Widerlegungsbetriebsfall möglichst schnell aufzufinden. Da Digitalschaltungen immer umfangreicher werden, führt ein einfaches Durchprobieren aller möglichen Betriebsfälle zum Auffinden eines Widerlegungsbetriebsfalls nur unter einem sehr hohen Zeitaufwand zum Ziel. Daher ist es bekannt, verschiedene Strategien einzusetzen, um den Nachweis zu führen, ob es wenigstens einen Widerlegungsbetriebsfall gibt, wobei es nur von Bedeutung ist, ob es wenigstens einen derartigen Widerlegungsbetriebsfall gibt. Wie ein solcher vorhandener Widerlegungsbetriebsfall aussieht, ist für die Erfindung nicht von grundsätzlicher Bedeutung.

Bei der Verifikation kann die wenigstens eine logische Funktion, die das Verhalten der Digitalschaltung beschreibt, vorab analysiert werden, um eine erfolgversprechende Strategie festzulegen, nach der unterschiedliche Betriebsfälle oder Gruppen von ähnlich wirkenden Betriebsfällen ausprobiert werden. Daneben ist es auch denkbar, Verfahren zur Verifikation einzusetzen, bei denen keine Simulation der Digitalschaltung bzw. das Anwenden der wenigstens einen logischen Funktion auch für eine begrenzte Gruppe von Betriebsfällen erforderlich ist, sondern allein durch formale Analyse des Modells der Digitalschaltung entschieden wird, ob es einen Widerlegungsbetriebsfall geben kann bzw. gibt oder nicht geben kann bzw. nicht gibt.

Das erfindungsgemäße Verfahren kann auf der Grundlage einer synthetisierbaren Schaltungsbeschreibung oder einer formalen Eigenschaftssuite durchgeführt werden. Eine Eigenschaftssuite ist ein Satz von Eigenschaften, die in einer formalen Eigenschaftssprache formuliert sind, wie beispielsweise Sugar oder System Verilog Assertions. Bei der Verwendung einer Eigenschaftssuite bzw. einem Satz von Eigenschaften kann bei der Durchführung des erfindungsgemäßen Verfahrens bei der Verifikation die Auswahl der formalen Eigenschaften innerhalb der Eigenschaftssuite eingeschränkt werden. So ist es möglich, bei der Prüfung nur einige der formalen Eigenschaften zu berücksichtigen, um beispielsweise die Untersuchung auf relevante und insbesondere in der Praxis auftretende Betriebsfälle zu beschränken. Dies bietet sich insbesondere dann an, wenn die Verwendung der Digitalschaltung in der vorgesehenen Umgebung dazu führt, dass bestimmte Betriebsfälle bzw. Gruppen von Betriebsfällen von vornherein ausgeschlossen sind.

Zu Beginn des Verfahrens wird der Schätzwert ohne vorangegangene Verifikation festgelegt, wobei der zuerst festgelegte Schätzwert vorzugsweise in Abhängigkeit des theoretischen maximalen Werts für die Schaltaktivität festgelegt wird. Dieser Höchstwert ist insbesondere wie zuvor ausgeführt die Anzahl der in der Digitalschaltung vorhandenen Kippglieder. Der erste Schätzwert kann beispielsweise ein festgelegter Prozentsatz der theoretisch maximalen Schaltaktivität sein.

Die Iteration wird abhängig von einem Abbruchkriterium abgebrochen und der zu diesem Zeitpunkt verwendete Schätzwert als Wert für die maximale oder minimale Schaltaktivität verwendet. Als Abbruchkriterium für die Iteration kommen verschiedene Bedingungen in Frage. Zum einen kann die Iteration abgebrochen werden, sobald die Schrittweite beim schrittweisen Verringern einen bestimmten Minimalwert erreicht. Dieser Minimalwert stellt dann die Obergrenze für den Fehler bei der Bestimmung der minimalen oder maximalen Schaltaktivität dar. Insbesondere wird der Minimalwert so gewählt, dass er kleiner als eine geforderte Genauigkeit bei der Bestimmung der minimalen und maximalen Schaltaktivität ist.

Weiterhin kann die Iteration nach einer festgelegten Anzahl von Iterationsschritten abgebrochen werden.

In einer vorteilhaften Weiterbildung wird am Ende der Iteration der zuletzt als vorhanden ermittelte Widerlegungsbetriebsfall ermittelt, um einen Betriebsfall zu gewinnen, der zu einer zumindest im Wesentlichen maximalen bzw. minimalen Schaltaktivität innerhalb der Digitalschaltung führt. Dieser Widerlegungsbetriebsfall, der als Testmuster aufgefasst werden kann, kann zu weiteren verschiedenen Tests verwendet werden. Zum einen kann der Widerlegungsbetriebsfall dazu verwendet werden, um anhand eines geeigneten Modells der Digitalschaltung die minimale oder maximale Leistungsaufnahme zu ermitteln. Dazu kann ein anderes Verfahren oder Rechnerprogramm eingesetzt werden, als es zur Verifikation eingesetzt wurde. Ebenso kann dabei unter Umständen ein anderes Modell der Digitalschaltung erforderlich sein, als es bei der Verifikation verwendet wurde.

Ferner kann der Widerlegungsbetriebsfall auch dazu verwendet werden, das Design der Digitalschaltung zu ändern, um insbesondere die maximale Schaltaktivität der Digitalschaltung zu verringern.

In einer vorteilhaften Ausbildung wird ein Widerlegungsbetriebsfall dazu verwendet, um eine Abdeckung bzw. ein Coverage zu ermitteln, welches die Anzahl der Elemente innerhalb der Digitalschaltung darstellt, die bei der Durchführung der Prüfung relevant waren bzw. Auswirkungen auf die Prüfung gehabt haben. Diese Abdeckung oder Coverage ist immer auf wenigstens eine formale Eigenschaft der Digitalschaltung bezogen, deren Einhaltung Grundlage'der Prüfung bzw. der Verifikation war. Demzufolge kann die Abdeckung oder Coverage sowohl in Bezug auf die Suche nach der minimalen Schaltaktivität als auch nach der maximalen Schaltaktivität und weiterhin für verschiedene formale Eigenschaften der Digitalschaltung oder Kombinationen von formalen Eigenschaften berechnet werden. Die Abdeckung oder Coverage kann zu Diagnosezwecken der Digitalschaltung verwendet werden. Dabei kann die Abdeckung oder Coverage nicht nur den Anteil der bei der Prüfung maßgeblichen Elemente anzeigen, sondern unter Umständen auch, welche der Elemente der Digitalschaltung bei der Prüfung maßgeblich waren. Auf diese Weise können beispielsweise tote Pfade innerhalb der Digitalschaltung ermittelt werden, die keinen Beitrag zum Erfüllen der geforderten formalen Eigenschaften liefern.

Das erfindungsgemäße Verfahren kann insbesondere in einer Datenverarbeitungseinrichtung wie einem programmierbaren Rechner durchgeführt werden, wobei die Erfindung auch in einem Datenträger mit geeigneten Steueranweisungen implementiert sein kann, wobei die Steueranweisungen derart eingerichtet sind, dass eine entsprechend eingerichtete programmierbare Datenverarbeitungseinrichtung nach Einlesen der Steueranweisungen das erfindungsgemäße Verfahren ausführt.

Die Erfindung wird nachfolgend anhand eines bevorzugten Ausführungsbeispiels unter Bezugnahme auf die beigefügte Zeichnung näher erläutert.

Figur 1 ist ein schematisches Blockdiagramm der Verfahrensschritte beim Ermitteln der maximalen Schaltaktivität, und

Figur 2 ist ein schematisches Blockdiagramm der Verfahrensschritte beim Ermitteln der minimalen Schaltaktivität einer Digitalschaltung.

Bei dem nachstehend beschriebenen Ausführungsbeispiel wird gemäß dem erfindungsgemäßen Verfahren die minimale und die maximale Schaltaktivität einer Digitalschaltung bestimmt, wobei die Digitalschaltung in Form eines funktionalen Modells vorliegt, bei dem eine Reihe von Eigenschaften definiert ist, die die Digitalschaltung erfüllt. Im Folgenden wird zur Bezeichnung der Schaltaktivität der Buchstabe k verwendet, wobei der Schätzwert für die Schaltaktivität und der am Ende des Verfahrens erhaltene Wert für die Schaltaktivität nicht unterschiedlich bezeichnet werden. Die Bezeichnung P(k) wird im Folgenden verwendet, um den wenigstens einen Widerlegungsbetriebsfall zu kennzeichnen, der zumindest im Wesentlichen zu einer bestimmten Schaltaktivität k führt.

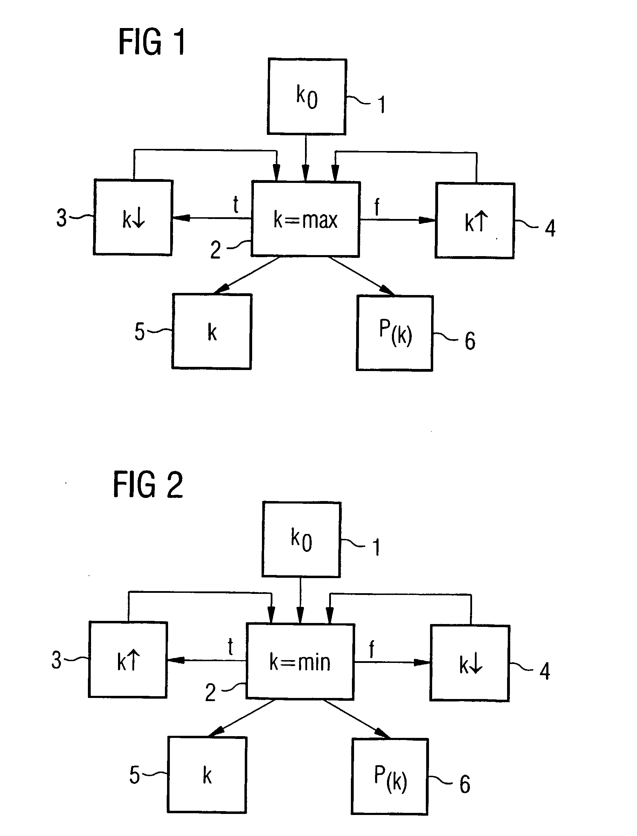

Bei der in Figur 1 dargestellten Ermittlung der maximalen Schaltaktivität beginnt das Verfahren mit Block 1, in dem ein Startwert k₀ als Schätzwert der Schaltaktivität vorgegeben wird. An den Block 1 schließt sich der Block 2 an, der eine Verifizierung beinhaltet, ob der aktuelle Schätzwert k tatsächlich der maximale Wert für die Schaltaktivität sein kann oder ob sich ein Widerlegungsbetriebsfall finden lässt, der die Annahme widerlegt, dass der derzeitige Schätzwert k tatsächlich der maximale Wert sein kann. Falls ein Widerlegungsbetriebsfall gefunden wird und die Annahme falsch (false) war, verzweigt das Verfahren zu Block 4, in dem der Schätzwert k um eine Schrittweite erhöht wird. Falls die Annahme richtig (true) war und sich kein Widerlegungsbetriebsfall finden ließ, wird zu Block 3 verzweigt, indem der Schätzwert k um eine Schrittweite verringert wird. Sowohl die in Block 3 als auch die in Block 4 verwendete Schrittweite verringert sich bei jedem Verfahrensschritt. Innerhalb der Abfrage in Block 2 ist weiterhin eine Überprüfung implementiert, ob die Anzahl der bereits durchgeführten Iterationsschritte eine Maximalanzahl erreicht hat. Wenn die Zahl der Iterationsschritte die Maximalanzahl erreicht hat, beendet der Verifikationsblock 2 die Iteration und verzweigt zu den beiden Blöcken 5 und 6, in denen zum einen in Block 5 der aktuelle Schätzwert k als Wert für maximale Schaltaktivität der Digitalschaltung festgelegt wird und indem zum anderen in Block 6 der zuletzt als vorhanden ermittelte Widerlegungsbetriebsfall P(k) ermittelt und ausgegeben wird. Dieser letzte Widerlegungsbetriebsfall P(k) wird in weiteren nicht dargestellten Verfahrensschritten entweder zu Diagnosezwecken oder zur Berechnung der tatsächlichen Leistungsaufnahme bei maximaler Schaltaktivität verwendet. An dieser Stelle sei bemerkt, dass die maximale Leistungsaufnahme einer Digitalschaltung nicht notwendigerweise bei der maximalen Schaltaktivität auftreten muss, diese Annahme jedoch in aller Regel zutrifft.

In Figur 2 ist die Durchführung des Verfahrens zur Ermittlung der minimalen Schaltaktivität beschrieben. Die in Figur 2 im Blockdiagramm auftretenden Blöcke entsprechen denen aus Figur 1 und wurden mit den gleichen Bezugsziffern versehen. Im Gegensatz zur Ermittlung der maximalen Schaltaktivität wird bei dem in Figur 2 dargestellten Verfahren beim Verifikationsblock 2 nicht ermittelt, ob der Schätzwert k der maximale sein könnte, sondern ob er der minimale sein könnte, und wird dazu versucht, einen Widerlegungsbetriebsfall aufzufinden, bei dem die Schaltaktivität noch geringer ist. Falls ermittelt wird, dass die Annahme falsch (false) ist und die Existenz eines geeigneten Widerlegungsbetriebsfalls mit geringerer Schaltaktivität nachgewiesen werden konnte, wird zu Block 4 verzweigt, in dem der Schätzwert k um eine Schrittweite verringert und die Verifikation in Block 2 wiederholt wird. Wenn umgekehrt die Annahme richtig (true) ist und die Existenz eines Widerlegungsbetriebsfall geringerer Schaltaktivität nicht nachgewiesen werden konnte, wird zu Block 3 verzweigt, dort der Schätzwert k um eine Schrittweite erhöht und die Verifikation in Block 2 wiederholt. Ähnlich wie bei der Ermittlung der maximalen Schaltaktivität wird die Iteration nach einer bestimmten Höchstanzahl an Iterationsschritten abgebrochen und zu den Blöcken 5 und 6 verzweigt, in denen zum einen der aktuelle Schätzwert als Wert für die minimale Schaltaktivität ausgegeben und der zuletzt als vorhanden nachgewiesene Widerlegungsbetriebsfall P(k) ermittelt und ausgegeben wird. Wie bei der Ermittlung der maximalen Schaltaktivität wird der Widerlegungsbetriebsfall P(k) zu Diagnosezwecken und zur Berechnung der minimalen Leistungsaufnahme der Digitalschaltung herangezogen.

Das im vorliegenden Ausführungsbeispiel beschriebene erfindungsgemäße Verfahren kann auf einer eigens dazu eingerichteten Datenverarbeitungseinrichtung ausgeführt werden oder kann in Form eines Datenverarbeitungsprogramms implementiert sein, das in einer programmierbaren Datenverarbeitungseinrichtung die Ausführung des erfindungsgemäßen Verfahrens bewirkt.

## Patentansprüche

1. Verfahren zum iterativen Ermitteln einer minimalen oder einer maximalen Schaltaktivität (k) einer Digitalschaltung anhand eines Modells der Digitalschaltung mittels einer Datenverarbeitungseinrichtung, bei welchem Verfahren zum Ermitteln der minimalen Schaltaktivität (k) eine Prüfung durchgeführt wird, ob es wenigstens einen Nachweisbetriebsfall der Digitalschaltung gibt, in dem die Schaltaktivität (k) geringer als ein Schätzwert (k) ist, und die Prüfung bejahendenfalls mit einem um eine Schrittweite verringerten Schätzwert (k) und verneinendenfalls mit einem um eine Schrittweite erhöhten Schätzwert (k) wiederholt wird, bzw. zum Ermitteln der maximalen Schaltaktivität (k) eine Prüfung durchgeführt wird, ob es wenigstens einen Nachweisbetriebsfall der Digitalschaltung gibt, in dem die Schaltaktivität (k) größer als ein Schätzwert (k) ist, und die Prüfung bejahendenfalls mit einem um eine Schrittweite erhöhten Schätzwert (k) und verneinendenfalls mit einem um eine Schrittweite verringerten Schätzwert (k) wiederholt wird, wobei in dem Verfahren eine Überprüfung implementiert ist, ob die Anzahl an bereits durchgeführten Iterationsschritten eine Höchstzahl erreicht hat, und
das Verfahren bei Erreichen der Höchstanzahl beendet wird.

2. Verfahren nach Anspruch 1, **dadurch gekennzeichnet, dass** bei Ausführung des Verfahrens auf der Datenverarbeitungseinrichtung automatisch bei jeder Wiederholung der Prüfung die Schrittweite verringert wird.

3. Verfahren nach Anspruch 2, **dadurch gekennzeichnet, dass** das Verfahren beendet wird, sobald die Schrittweite eine Mindestschrittweite erreicht hat.

4. Verfahren zum iterativen Ermitteln einer minimalen oder einer maximalen Schaltaktivität (k) einer Digitalschaltung anhand eines Modells der Digitalschaltung mittels einer Datenverarbeitungseinrichtung, bei welchem Verfahren zum Ermitteln der minimalen Schaltaktivität (k) eine Prüfung durchgeführt wird, ob es wenigstens einen Nachweisbetriebsfall der Digitalschaltung gibt, in dem die Schaltaktivität (k) geringer als ein Schätzwert (k) ist, und die Prüfung bejahendenfalls mit einem um eine Schrittweite verringerten Schätzwert (k) und verneinendenfalls mit einem um eine Schrittweite erhöhten Schätzwert (k) wiederholt wird, bzw. zum Ermitteln der maximalen Schaltaktivität (k) eine Prüfung durchgeführt wird, ob es wenigstens einen Nachweisbetriebsfall der Digitalschaltung gibt, in dem die Schaltaktivität (k) größer als ein Schätzwert (k) ist, und die Prüfung bejahendenfalls mit einem um eine Schrittweite erhöhten Schätzwert (k) und verneinendenfalls mit einem um eine Schrittweite verringerten Schätzwert (k) wiederholt wird, wobei bei Ausführung des Verfahrens auf der Datenverarbeitungseinrichtung automatisch bei jeder Wiederholung der Prüfung die Schrittweite verringert wird und das Verfahren beendet wird, sobald die Schrittweite eine Mindestschrittweite erreicht hat.

5. Verfahren nach Anspruch 4, **dadurch gekennzeichnet, dass** in dem Verfahren eine Überprüfung implementiert ist, ob die Anzahl an bereits durchgeführten Iterationsschritten eine Höchstzahl erreicht hat, und
das Verfahren bei Erreichen der Höchstanzahl beendet wird.

6. Verfahren nach einem der vorhergehenden Ansprüche, **dadurch gekennzeichnet,**
**dass** zu Beginn die Prüfung mit einem Schätzwert (k0) durchgeführt wird, der in Abhängigkeit der Anzahl an Kippgliedern innerhalb der Digitalschaltung ist.

7. Verfahren nach einem der vorhergehenden Ansprüche, **dadurch gekennzeichnet,**
**dass** am Ende des Verfahrens der zuletzt als vorhanden ermittelte Nachweisbetriebsfall (P(k)) ermittelt wird und in Abhängigkeit dieses Nachweisbetriebsfalls (P(k)) die Leistungsaufnahme der Digitalschaltung bei der minimalen oder bei der maximalen Schaltaktivität ermittelt wird.

8. Verfahren nach einem der vorhergehenden Ansprüche, **dadurch gekennzeichnet,**
**dass** am Ende des Verfahrens der zuletzt als vorhanden ermittelte Nachweisbetriebsfall (P(k)) ermittelt wird und in Abhängigkeit dieses Nachweisbetriebsfalls (P(k)) ein Mass für den Anteil der Elemente der Digitalschaltung ermittelt wird, die im Nachweisbetriebsfall (P(k)) bei einer Verifizierung wenigstens einer Schalteigenschaft beteiligt waren.

9. Verfahren nach einem der vorhergehenden Ansprüche, **dadurch gekennzeichnet,**
**dass** bei der Durchführung der Prüfung nur das Erfülltsein wenigstens einer Schalteigenschaft gefordert wird.

10. Vorrichtung zum Ermitteln einer minimalen oder einer maximalen Schaltaktivität (k) einer Digitalschaltung anhand eines Modells der Digitalschaltung mit Datenverarbeitungsmitteln, die derart eingerichtet sind, dass sie
zum Ermitteln der minimalen Schaltaktivität (k) eine Prüfung durchführen, ob es wenigstens einen Nachweisbetriebsfall der Digitalschaltung gibt, in dem die Schaltaktivität (k) geringer als ein Schätzwert (k) ist, und die Prüfung bejahendenfalls mit einem um eine Schrittweite verringerten Schätzwert (k) und verneinendenfalls mit einem um eine Schrittweite erhöhten Schätzwert (k) wiederholen, bzw.
zum Ermitteln der maximalen Schaltaktivität (k) eine Prüfung durchführen, ob es wenigstens einen Nachweisbetriebsfall der Digitalschaltung gibt, in dem die Schaltaktivität (k) grösser als ein Schätzwert (k) ist, und die Prüfung bejahendenfalls mit einem um eine Schrittweite erhöhten Schätzwert (k) und verneinendenfalls mit einem um eine Schrittweite verringerten Schätzwert (k) wiederholen, wobei eine Überprüfung implementiert ist, ob die Anzahl an bereits durchgeführten Iterationsschritten eine Höchstzahl erreicht hat, und
die Prüfung nach Erreichen der Höchstanzahl an Wiederholungen beendet wird.

11. Vorrichtung nach Anspruch 10, **dadurch gekennzeichnet,**
**dass** die Vorrichtung zur Durchführung eines Verfahrens nach einem der Ansprüche 1 bis 3 oder einem der Ansprüche 6 bis 9, insoweit von einem der Ansprüchen 1 bis 3 abhängig, eingerichtet ist.

12. Vorrichtung zum Ermitteln einer minimalen oder einer maximalen Schaltaktivität (k) einer Digitalschaltung anhand eines Modells der Digitalschaltung mit Datenverarbeitungsmitteln, die derart eingerichtet sind, dass sie
zum Ermitteln der minimalen Schaltaktivität (k) eine Prüfung durchführen, ob es wenigstens einen Nachweisbetriebsfall der Digitalschaltung gibt, in dem die Schaltaktivität geringer als ein Schätzwert ist, und die Prüfung bejahendenfalls mit einem um eine Schrittweite verringerten Schätzwert und verneinendenfalls mit einem um eine Schrittweite erhöhten Schätzwert wiederholen, bzw.
zum Ermitteln der maximalen Schaltaktivität (k) eine Prüfung durchführen, ob es wenigstens einen Nachweisbetriebsfall der Digitalschaltung gibt, in dem die Schaltaktivität grösser als ein Schätzwert ist, und die Prüfung bejahendenfalls mit einem um eine Schrittweite erhöhten Schätzwert und verneinendenfalls mit einem um eine Schrittweite verringerten Schätzwert wiederholen, wobei automatisch bei jeder Wiederholung der Prüfung die Schrittweite verringert wird und die Prüfung beendet wird, sobald die Schrittweite eine Mindestschrittweite erreicht hat.

13. Vorrichtung nach Anspruch 12, **dadurch gekennzeichnet,**
**dass** die Vorrichtung zur Durchführung eines Verfahrens nach einem der Ansprüche 4 bis 9 eingerichtet ist.

14. Digitales Speichermedium, mit elektronisch auslesbaren Steuersignalen, die so mit einem programmierbaren Computersystem zusammenwirken können, dass dieses ein Verfahren nach einem der Ansprüche 1 bis 9 ausführt.

## Claims

1. A method of iterative determining of a minimum or maximum switching activity (k) of a digital circuit using a model of the digital circuit provided by dint of a data processing unit, in which method the determining of the minimum switching activity (k) comprises carrying out a test, whether there is at least a validated state of operation of the digital circuit, in which the switching activity (k) is lower than an estimate value (k), and the test, in case of a positive result will be repeated with an estimate value (k), reduced by an increment, and in case of a negative result will be repeated with an estimate value (k), increased by an increment, or the determining of the maximum switching activity comprises carrying out a test, whether there is at least a validated state of operation of the digital circuit, in which the switching activity (k) is greater than an estimate value (k), and the test, in case of a positive result will be repeated with an estimate value (k), increased by an increment, and in case of a negative result will be repeated with an estimate value (k) reduced by an increment, wherein the method implements an assessment, as to whether the number of already carried out iterative steps has reached a maximum number, and the method will be terminated when the maximum number is reached.

2. The method according to claim 1, **characterized in that** during the execution of the method on the data processing unit the increment will be automatically reduced in every iteration of the test.

3. The method according to claim 2, **characterized in that** the method will be terminated as soon as the increment reaches a minimum increment.

4. A method of iterative determining of a minimum or maximum switching activity (k) of a digital circuit using a model of the digital circuit provided by dint of a data processing unit, in which method the determining of the minimum switching activity (k) comprises carrying out a test, whether there is at least a validated state of operation of the digital circuit, in which the switching activity (k) is lower than an estimate value (k), and the test, in case of a positive result will be repeated with an estimate value (k), reduced by an increment, and in case of a negative result will be repeated with an estimate value (k), increased by an increment, or the determining of the maximum switching activity comprises carrying out a test, whether there is at least a validated state of operation of the digital circuit, wherein the switching activity (k) is greater than an estimate value (k), and the test, in case of a positive result will be repeated with an estimate value (k), increased by an increment, and in case of a negative result will be repeated with an estimate value (k) reduced by an increment, wherein during the execution of the method on the data processing unit, the increment will be automatically reduced for each iteration of the test and the method will be terminated as soon as the increment reaches a minimum increment.

5. The method according to claim 4, **characterized in that** the method implements an assessment, whether the number of iterations already carried out has reached a maximum number, and the method will be terminated as soon as the maximum number is reached.

6. The method according to any one of the preceding claims, **characterized in that** at the beginning the test is carried out with an estimate value (k0) depending on the numbers of flip-flop elements within the digital circuit.

7. The method according to any one of the preceding claims, **characterized in that** at the end of the method the last existing validated state of operation (P(k)) is determined and the power consumption of the digital circuit is determined during minimum or maximum switching activity dependent on this validated state of operation (P(k)).

8. The method according to any one of the preceding claims, **characterised in that** at the end of the method the last existing validated state of operation (P(k)) is determined, and a measure being determined for the portion of the elements of the digital circuit, being involved in the validated state of operation (P(k)) during a verification of at least one switching property, depending upon the last existing determined validated state of operation (P(k)).

9. The method according to any one of the preceding claims, **characterized in that** during the execution of the test only the fulfillment of at least one switching property is requested.

10. An apparatus for determining of a minimum or a maximum switching activity (k) of a digital circuit using a model of the digital circuit with data processing means that are adapted in such a way as
to carry out a test for determining the minimum switching activity (k) as to, whether there is at least a validated state of operation of the digital circuit, wherein the switching activity (k) is lower than an estimate value (k), and the test, in case of a positive result will be repeated with an estimate value (k), reduced by an increment, and in case of a negative result, will be repeated with an estimate value (k), increased by an increment, or to carry out a test for determining the maximum switching activity (k) as to, whether there is at least a validated state of operation of the digital circuit, wherein the switching activity (k) is greater than an estimate value (k), and the test, in case of a positive result will be repeated with an estimate value (k), increased by an increment, and in case of a negative result will be repeated with an estimate value (k) reduced by an increment, wherein an assessment is implemented whether the number iterations already carried out has reached a maximum number, and the test is terminated after reaching the maximum number of iterations.

11. The apparatus according to claim 10, **characterized in that** the apparatus is adapted for execution of the method according to any one of claims 1 to 3, or any one of claims 6 to 9, as long as they are dependent upon any one of claims 1 to 3.

12. An apparatus for determining of a minimum or a maximum switching activity (k) of a digital circuit using a model of the digital circuit with data processing means that are adapted in such a way as
to carry out a test for determining the minimum switching activity (k) as to, whether there is at least a validated state of operation of the digital circuit, wherein the switching activity (k) is lower than an estimate value (k), and the test, in case of a positive result will be repeated with an estimate value (k), reduced by an increment, and in case of a negative result, will be repeated with an estimate value (k), increased by an increment, or to carry out a test for determining the maximum switching activity (k) as to, whether there is at least a validated state of operation of the digital circuit, wherein the switching activity (k) is greater than an estimate value (k), and the test, in case of a positive result will be repeated with an estimate value (k), increased by an increment, and in case of a negative result, will be repeated with an estimate value (k) reduced by an increment, wherein automatically the increment is reduced for each iteration of the test and the test is terminated as soon as the increment has reached a minimum increment.

13. The apparatus according to claim 12, **characterized in that** that the apparatus is adapted for execution of the method according to any one of the claims 4 to 9.

14. A digital memory media, with electronically readable control signals which can cooperate with programmable computer systems, such that it executes the method according to any one of claims 1 to 9.

## Revendications

1. Procédé de détermination itératif d'une activité de commutation (k) minimale ou maximale d'un circuit numérique à l'aide d'un modèle du circuit numérique au moyen d'un dispositif de traitement de données, procédé par lequel, soit pour la détermination de l'activité de commutation (k) minimale, un test est effectué s'il existe au moins un cas opérationnel de détection du circuit numérique dans lequel l'activité de commutation (k) est inférieure à une valeur estimative (k), et le test est répété dans les cas positifs avec une valeur estimative (k) réduite d'un incrément, et dans les cas négatifs avec une valeur estimative (k) augmentée d'un incrément, soit pour la détermination de l'activité de commutation (k) maximale, un test est effectué s'il existe au moins un cas opérationnel de détection du circuit numérique dans lequel l'activité de commutation (k) est supérieure à une valeur estimative (k), et le test est répété dans les cas positifs avec une valeur estimative (k) augmentée d'un incrément, et dans les cas négatifs avec une valeur estimative (k) réduite d'un incrément, dans le procédé une vérification etant implémentée de savoir si le nombre d'itérations déjà réalisées a atteint un nombre maximal, et le procédé est terminé lorsque nombre maximal est atteint.

2. Procédé selon la revendication 1, **caractérisé en ce que**, lors du déroulement du procédé sur le dispositif de traitement de données, l'incrément est automatiquement diminuée à chaque répétition du test.

3. Procédé selon la revendication 2, **caractérisé en ce que** le procédé est arrêté aussitôt que l'incrément a atteint un incrément minimal.

4. Procédé de détermination itératif d'une activité de commutation (k) minimale ou maximale d'un circuit numérique à l'aide d'un modèle du circuit numérique au moyen d'un dispositif de traitement de données, procédé par lequel, soit pour la détermination de l'activité de commutation (k) minimale, un test est effectué s'il existe au moins un cas opérationnel de détection du circuit numérique dans lequel l'activité de commutation (k) est inférieure à une valeur estimative (k), et le test est répété dans les cas positifs avec une valeur estimative (k) réduite d'un incrément, et dans les cas négatifs avec une valeur estimative (k) augmentée d'un incrément, soit pour la détermination de l'activité de commutation (k) maximale, un test est effectué s'il existe au moins un cas opérationnel de détection du circuit numérique dans lequel l'activité de commutation (k) est supérieure à une valeur estimative (k), et le test est répété dans les cas positifs avec une valeur estimative(k) augmentée d'un incrément, et dans les cas négatifs avec une valeur estimative (k) réduite d'un incrément, dans lequel, lors du déroulement du procédé sur le dispositif de traitement de données, l'incrément est automatiquement diminuée à chaque répétition du test, et le procédé est arrêté aussitôt que l'incrément a atteint un incrément minimal.

5. Procédé selon la revendication 4, **caractérisé en ce que**, dans le procédé, une vérification est implémentée de savoir si le nombre d'itérations déjà réalisées a atteint un nombre maximal, et le procédé est terminé lorsque nombre maximal est atteint.

6. Procédé selon l'une quelconque des revendications précédentes, **caractérisé en ce que,** au début, le test est effectué avec une valeur estimative (k0), qui dépend du nombre de bascules à l'intérieur du circuit numérique.

7. Procédé selon l'une quelconque des revendications précédentes, **caractérisé en ce que,** à la fin du procédé, le dernier cas opérationnel de détection (P(k)) déterminé est déterminé en tant que cas opérationnel de détection (P(k)) effectif, et, en fonction de ce cas opérationnel de détection (P(k)), la puissance utile du circuit numérique est déterminée par l'activité de commutation minimale ou maximale.

8. Procédé selon l'une quelconque des revendications précédentes, **caractérisé en ce que,** à la fin du procédé, le dernier cas opérationnel de détection (P(k)) déterminé est déterminé en tant que cas opérationnel de détection (P(k)) effectif, et, en fonction de ce cas opérationnel de détection (P(k)), une mesure pour la proportion des éléments du circuit numérique est déterminée, qui, dans le cas opérationnel de détection (P(k)), ayant participée à une vérification d'au moins une propriété de commutation.

9. Procédé selon l'une quelconque des revendications précédentes, **caractérisé en ce que,** lors de la réalisation du test, seulement l'accomplissement d'au moins une propriété de commutation est sollicité.

10. Dispositif de détermination d'une activité de commutation (k) minimale ou maximale d'un circuit numérique à l'aide d'un modèle du circuit numérique avec des moyens de traitement de données, qui sont agencés de sorte que:
soit pour la détermination de l'activité de commutation (k) minimale, ils effectuent un test s'il existe au moins un cas opérationnel de détection du circuit numérique dans lequel l'activité de commutation (k) est inférieure à une valeur estimative (k), et répètent le test dans les cas positifs avec une valeur estimative(k) réduite d'un incrément, et dans les cas négatifs avec une valeur estimative(k) augmentée d'un incrément,
soit pour la détermination de l'activité de commutation (k) maximale ils effectuent un test s'il existe au moins un cas opérationnel de détection du circuit numérique dans lequel l'activité de commutation (k) est supérieure à une valeur estimative (k), et répètent le test dans les cas positifs avec une valeur estimative (k) augmentée d'un incrément, et dans les cas négatifs avec une valeur estimative (k) réduite d'un incrément, une vérification etant implémentée, si le nombre d'itérations déjà réalisées a atteint un nombre maximal, et le test est terminé lorsque nombre maximal est atteint.

11. Dispositif selon la revendication 10, **caractérisé en ce que** le dispositif est agencé pour réaliser un procédé selon l'une des revendications 1 à 3 ou selon l'une des revendications 6 à 9, lorsque dépendante de l'une des revendications 1 à 3.

12. Dispositif de détermination d'une activité de commutation (k) minimale ou maximale d'un circuit numérique à l'aide d'un modèle du circuit numérique avec des moyens de traitement de données, qui sont agencés de sorte que:
soit pour la détermination de l'activité de commutation (k) minimale, ils effectuent un test s'il existe au moins un cas opérationnel de détection du circuit numérique dans lequel l'activité de commutation (k) est inférieure à une valeur estimative (k), et répètent le test dans les cas positifs avec une valeur estimative (k) réduite d'un incrément, et dans les cas négatifs avec une valeur estimative (k) augmentée d'un incrément,
soit pour la détermination de l'activité de commutation (k) maximale, ils effectuent un test s'il existe au moins un cas opérationnel de détection dans lequel l'activité de commutation (k) est supérieure à une valeur estimative (k), et répètent le test dans les cas positifs avec une valeur estimative (k) augmentée d'un incrément, et dans les cas négatifs avec une valeur estimative (k) réduite d'un incrément, l'incrément etant automatiquement diminué à chaque répétition du test, et le procédé est arrêté aussitôt que l'incrément a atteint un incrément minimal.

13. Dispositif selon la revendication 12, **caractérisé en ce que** le dispositif est agencé pour réaliser un procédé selon l'une des revendications 4 à 9.

14. Support de mémorisation numérique, avec des signaux de commande lisibles électroniquement, qui peuvent fonctionner conjointement avec un système d'ordinateur programmable de telle sorte de réaliser un procédé selon l'une des revendications 1 à 9.
